# EUROPÄISCHE PATENTANMELDUNG

(11) **EP 0 668 685 A1**
(43) Veröffentlichungstag der Anmeldung: **23.08.1995**
(21) Anmeldenummer: 95100406.8
(22) Anmeldetag: 13.01.1995
(51) Int. Cl.: H04M 1/65, G06F 1/30, G11C 5/14

(54) **Schaltungsanordnung zur Rettung von Daten bei Netzspannungsausfall für Anrufbeantworter mit digitaler Sprachspeicherung in Kommunikations-Endgeräten**

(30) Priorität: 19.02.1994 DE 4405897
(71) Anmelder: DeTeWe - Deutsche Telephonwerke Aktiengesellschaft & Co., D-10997 Berlin (DE)
(72) Erfinder: Baumeister, Rolf, D-10551 Berlin (DE)

(57) **Zusammenfassung**

Für die Rettung von Daten von dynamischen Schreib-Lese-Speichern in Anrufbeantwortern bei Netzspannungsausfall wird vorgeschlagen, Schreib-Lese-Speicher mit extrem niedriger Stromaufnahme im Selbstauffrischungsmodus zu verwenden und einen Kondensator extrem hoher Kapazität als Energiespeicher einzusetzen.

## Beschreibung

Die Erfindung betrifft eine Schaltungsanordnung zur Rettung von Daten bei Netzspannungsausfall für Anrufbeantworter mit digitaler Sprachspeicherung in Kommunikations-Endgeräten.

Bei einer digitalen Sprachspeicherung in Anrufbeantwortern werden die Sprachdaten von einem digitalen Signalprozessor komprimiert und in Schreib-Lese-Speichern abgelegt (DE 31 18 420 A1

Ein Nachteil derartiger Sprachspeicherung ist die Abhängigkeit der Sprach-Lese-Speicher von ständiger Energiezufuhr, da bei deren Ausfall die Daten verlorengehen.

Abhilfe kann eine Batterie-Pufferung schaffen. Diese wiederum ist mit zusätzlichen Kosten in der Beschaffung und in ihrer Entsorgung nach dem Entladen verbunden. Zudem sind längere Energieunterbrechungen in Kommunikationsnetzen unwahrscheinlich.

Anstelle einer Batterie einen Kondensator einzusetzen ist insofern problematisch, da dessen Kapazität bei dem relativ hohen Strombedarf von dynamischen Standard-Schreib-Lese-Speichern zu gering ist.

Der Erfindung lag die Aufgabe zugrunde, ohne den Einsatz von Batterien bei einem Netzspannungsausfall einen Datenerhalt in Schreib-Lese-Speichern von Anrufbeantwortern mit digitaler Sprachspeicherung für eine bestimmte Zeit, z. B. eine Stunde, zu gewährleisten.

Diese Aufgabe ist durch die Erfindung gelöst, wie sie im Kennzeichnungsteil des ersten Patentanspruches dargelegt ist. Weitere vorteilhafte Maßnahmen sind Gegenstand des Unteranspruches.

Durch die Kombination eines Stützkondensators extrem hoher Kapazität mit Schreib-Lese-Speichern extrem niedriger Stromaufnahme im Selbstauffrischungsmodus ist die Forderung des Datenerhaltes über eine vorgegebene Zeitspanne erfüllt.

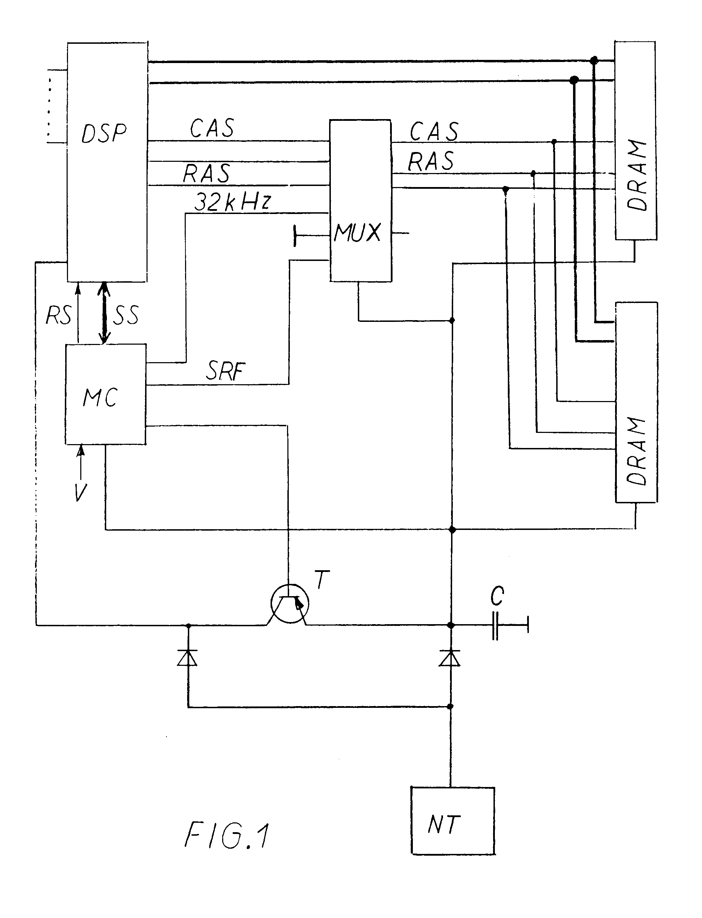

Anhand einer aus zwei Figuren bestehenden Zeichnung wird die Erfindung nachfolgend näher beschrieben. In der Zeichnung zeigen die
Fig. 1 das Blockschaltbild eines Anrufbeantworters mit digitaler Sprachspeicherung und die
Fig. 2 ein Diagramm der Impulserzeugung zum Einschalten eines Selbstauffrischungsmodus für Schreib-Lese-Speicher.

Im Anrufbeantworter werden als Schreib-Lese-Speicher DRAM spezielle dynamische Speicher eingesetzt, sogenannte "Silicon Files". Diese weisen einen Selbstauffrischungsmodus mit extrem niedriger Stromaufnahme im Vergleich zu dynamischen Standard-Schreib-Lese-Speichern auf. Der digitale Signalprozessor DSP, der die Daten komprimiert, steuert die dynamischen Schreib-Lese-Speicher DRAM über einen elektronischen Umschalter MUX an. Diese Ansteuerung geschieht über Spalten- und Zeilen-Adressenleitungen CAS, RAS. Vom Mikrocomputer MC liegt am elektronischen Umschalter MUX ständig ein 32-kHz-Signal an. Mit dem digitalen Signalprozessor DSP ist der Mikrocomputer MC über eine serielle Schnittstelle SS und eine Rücksetzleitung RS verbunden.

Bei einem Netzausfall, der durch eine nicht dargestellte Spannungsabfrage ermittelt und als Netzausfallsignal V dem Mikrocomputer MC übermittelt wird, ist im Falle einer gerade aufzuzeichnenden Nachricht der digitale Signalprozessor DSP solange mit Energie zu versorgen, bis diese Aktion ordnungsgemäß abgebrochen ist. Ein solcher Vorgang kann maximal 150 ms dauern. Hierzu ist ein Kondensator extrem hoher Kapazität, z. B. typisch 0,47 F, als Stützkondensator C vorgesehen. Dieser Stützkondensator C liegt parallel zur Speisespannung NT über einen Schalttransistor T am digitalen Signalprozessor DSP. Das Abbrechen der Aktion besteht darin, die Spalten- und Zeilen-Adressenleitungen CAS, RAS vom elektronischen Umschalter MUX in bestimmter Reihenfolge abzuschalten. Zunächst ist die Spalten-Adreßleitung CAS auf einen niedrigen Pegel zu setzen und der Selbstauffrischungsmodus der dynamischen Schreib-Lese-Speicher DRAM einzuschalten, indem die Zeilen-Adreßleitung RAS auf den 32-kHz-Takt umgeschaltet wird. Danach wird vom Mikrocomputer MC der Schalttransistor T umgesteuert, so daß die Energieversorgung des dynamischen Signalprozessors DSP durch den Stützkondensator C unterbrochen wird und dessen restliche Energie für den Datenerhalt in den dynamischen Schreib-Lese-Speichern DRAM zur Verfügung steht.

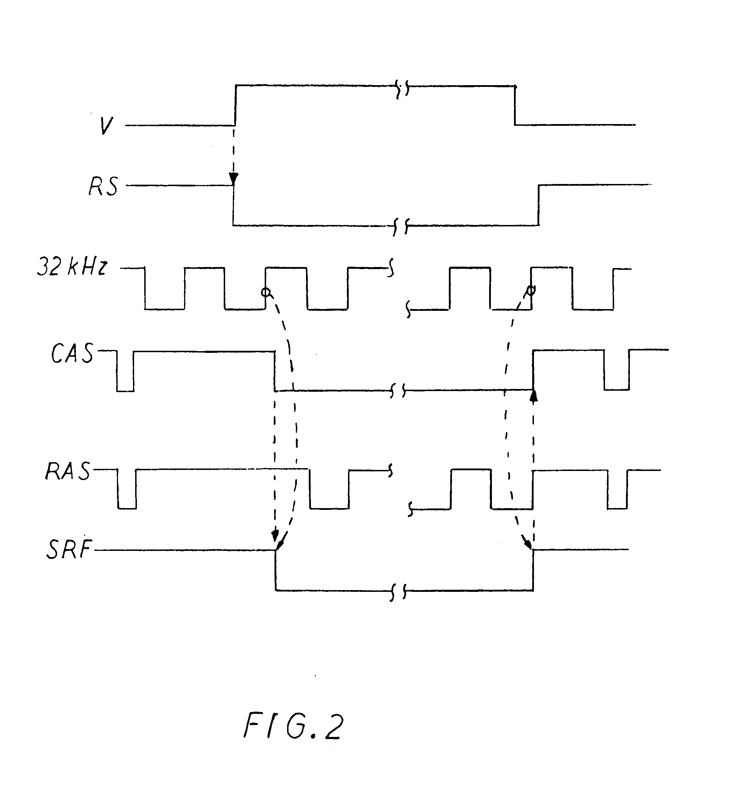

Die Bedingungen für das Erzeugen eines Impulses SRF zum Starten des Selbstauffrischungsmodus der dynamischen Schreib-Lese-Speicher DRAM sind auf einem hohen Pegel liegende Spalten- und Zeilen-Adressenleitungen, wenn ein Netzausfallsignal V eintritt. Der Impuls SRF für das Einschalten des Selbstauffrischungsmodus der dynamischen Schreib-Lese-Speicher DRAM wird außerhalb der Speicher DRAM erzeugt, indem der 32-kHz-Takt des Mikrocomputer MC verwendet wird. Das Diagramm (Fig. 2) für die Erzeugung des Impulses SRF des Selbstauffrischungsmodus verdeutlicht den Ablauf: Das Netzausfallsignal V bewirkt das Aussenden eines Rücksetzsignals DSPRS vom Mikrocomputer MC an den digitalen Signalprozessor DSP. Damit werden sämtliche Steuerausgänge auf einen hohen Pegel gelegt. Der elektronische Umschalter MUX wird erst umgesteuert, wenn das 32-kHz-Signal einen hohen Pegel erreicht hat. Somit ist gewährleistet, daß die Spalten-Adreßleitung CAS vor der Zeilen-Adreßleitung RAS auf einen niedrigen Pegel geschaltet wird. Der Impuls SRF wird vom Mikrocomputer MC zum Umsteuern des elektronischen Umschalters MUX erzeugt. Das Umsteuern des Umschalters MUX startet den Selbstauffrischungsmodus.

Nach Beendigung des Netzausfalls wird ein hoher Pegel des 32-kHz-Signals zur Rücksetzung des Impulses SRF und des elektronischen Umschalters MUX über die Spalten-Adreßleitung CAS genutzt.

## Patentansprüche

1. Schaltungsanordnung zur Rettung von Daten bei Netzspannungsausfall für Anrufbeantworter mit digitaler Sprachspeicherung in Kommunikations-Endgeräten, dadurch gekennzeichnet, daß dynamische Schreib-Lese-Speicher (DRAM) mit extrem niedriger Stromaufnahme im Selbstauffrischungsmodus von einem digitalen Signalprozessor (DSP) über einen elektronischen Umschalter (MUX) gesteuert werden, daß ein Stützkondensator (C) extrem hoher Kapazität parallel zur Speisespannung (NT) über einen Schalttransistor (T) am digitalen Signalprozessor (DSP) liegt und daß dem elektronischen Umschalter (MUX) vom zentralen Mikrocomputer (MC) des Kommunikations-Endgerätes ein 32-kHz-Signal zugeführt wird.

2. Schaltungsanordnung nach Anspruch 1, dadurch gekennzeichnet, daß der Selbstauffrischungsmodus der dynamischen Schreib-Lese-Speicher (DRAM) bei Ausfall der Speisespannung (NT) durch einen Impuls (SRF) ausgelöst wird, der außerhalb der Speicher (DRAM) in Abhängigkeit des 32-kHz-Signals des Mikrocomputers (MC) erzeugt wird.
